# EUROPEAN PATENT APPLICATION

(11) **EP 2 192 607 A2**
(43) Date of publication of application: **02.06.2010**
(21) Application number: 09252707.6
(22) Date of filing: 01.12.2009
(51) Int. Cl.: H01J 37/317

(54) **Vapor deposition electron beam current control**

(30) Priority: 01.12.2008 US 118812 P
(71) Applicant: United Technologies Corporation, Hartford, CT 06101 (US)
(72) Inventor: Kirushko, Volodymyr V., Kyiv 03022 (UA); Ryabenko, Sergiy I., Kyiv 04114 (UA); Neal, James W., Ellington, CT 06029 (US)
(74) Representative: Leckey, David Herbert

(57) **Abstract**

Systems (301) and methods are described that monitor electron beam current and voltage. The systems (301) and methods react to fault conditions such as arcing experienced during evaporation and deposition processes to shutdown and protect associated power supply equipment. The systems (301) and methods may provide online beam current control to provide stable operation of e-beam guns (303x) during heating and melting modes of operation.

## Description

### BACKGROUND

The disclosure relates generally to the field of vacuum deposition. More specifically, the disclosure relates to systems and methods for controlling electron beam filament current used in electron beam physical vapor deposition for aircraft engine turbine blades and accessories.

Today, vacuum deposition of thin films and coatings is evolving. This is true of their processes, equipment, applications and markets.

Electron beam physical vapor deposition (PVD) is a material coating technology where a coating, such as a metal, alloy, or ceramic is melted, vaporized in a vacuum, and then deposited on a work piece. The material to be deposited is converted to a vapor by physical means. Generally, the process deposits atoms or molecules one at a time. Since the process is performed in a vacuum, it is an environmentally friendly technology, suitable as a replacement for other coating processes in many applications. The technology is capable of producing coatings for a wide range of industrial applications.

PVD processes are atomistic where material vaporized from a solid or liquid source is transported as a vapor through a vacuum or low-pressure environment. When it contacts the work piece, it condenses. PVD processes are used to deposit films with thicknesses in the range of a few nanometers to thousands of nanometers, however, they can be used to form multilayer coatings, thick deposits and free-standing structures.

Vacuum evaporation is a PVD process where material from a thermal vaporization source reaches the substrate without collision with gas molecules in the space between the source and substrate. The trajectory of the vaporized material is in a line-of-sight.

The equipment used to generate a deposition environment is an integral part of the process. The principal parts of the deposition system are the deposition chamber, evaporation tools, fixtures (which hold the parts to be coated), and the vacuum pumping system (which removes gases and vapors from the deposition chamber).

Generating a vacuum reduces the gas pressure so that vaporized atoms have a long mean-free path and do not nucleate in the vapor to form soot. The vacuum also reduces the contamination level to the point that the desired film can be deposited. Fixtures hold the substrates to be coated and provide the motion, relative to the vaporization source. This is often necessary to give a uniform deposition over a large area, a complex surface or over many substrates. The deposition chamber is sized to contain the fixtures and provide room for accessories such as shutters, deposition rate monitors, heaters, etc. Proper design, construction, operation and maintenance are necessary to obtain a reproducible product with high yield and desired product throughput.

The vaporization source is typically a high-energy, electron beam (e-beam) gun that is focused and rastered over the surface of the source material. E-beams are either hot-cathode or hot-filament thermionic guns where the electrons are generated by a hot filament of a high temperature alloy such as tungsten. Beam electrons are generated by applying a constant voltage, typically 20,000 to 120,000 V to the cathode. Electron emission from the cathode is increased by bombarding it with electrons from an electrically heated filament, typically at 1000 V.

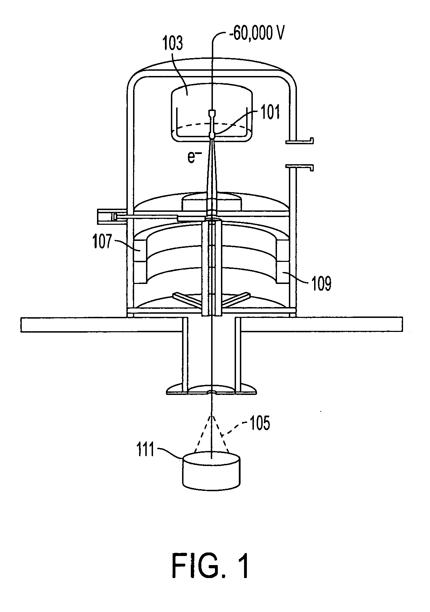

An axial, e-beam gun evaporation tool is shown in FIG. 1. During gun operation, the cathode 101 is heated electrically by passing a current through the filament 103 until it emits electrons 105 through thermionic emission. The electrons bombard the cathode 101, heating it and leading to its own electron emission. Once the cathode 101 has begun to emit electrons, electron bombardment from the cathode in combination with direct electric current heating increases the cathode temperature, increases its electron current emission density, and results in a larger emitting surface than would be achieved through cathode operation only.

Gun systems use electromagnets located within the body of the gun for beam focusing 107 and scanning 109. Beam scanning is an integral feature because it ensures rapid, uniform, controlled, atomistic evaporation from the largest possible target 111 surface.

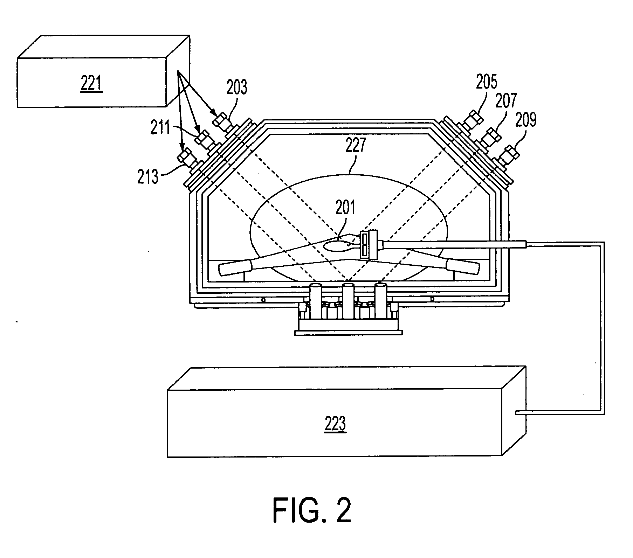

FIG. 2 is a diagram of an exemplary process. The work piece 201 is maintained at a specific temperature to ensure good adhesion of the evaporated material. Two 203, 205 of six e-beam guns are directed at trays containing crushed ceramic or graphite positioned adjacent to the work piece 201 for indirect heating. Up to four guns 207, 209, 211, 213 are used for evaporation. FIG. 2 also shows the e-beam directing system 221 and workpiece motion controller 223.

Specifying and controlling the maximum e-beam gun power for high or low vacuum evaporation systems is problematic because of the uncertainty involved in determining the magnitude of the various e-beam energy losses between generation of the beam and generation of the vapor. The amount of e-beam energy actually available for material evaporation depends upon the energy losses such as those experienced inside of a gun due to some fraction of the beam impinging on various portions of the gun, in the gas and vapor cloud 227 due to electron scattering collisions, from the evaporant material surface as a result of electron backscattering, through conduction into the crucible containing the melt material, from the radiating molten evaporant surface, and through convection caused by the gas jet blowing across the evaporant surface. With the above described energy losses and operating environment, problems related to electrical discharges manifest themselves from high voltage in the presence of high vapor. The vapor may become ionized resulting in interaction with the hot filament. An exemplary threshold for coaters is about 16kV accelerating voltage: below this voltage the beams do not penetrate the vapor very well. At operational voltages, arcing can occur. Arcing induces rapid, out of control filament current. Arcs caused by ionized vapors occur between the coater enclosure and the high-voltage circuits. Most often arcs occur in the guns and HV input circuits.

Pre-arc or non-arc interactions can occur between electron beam guns. This is evidenced by filament current fluctuations that may occur spontaneously or when the beam current is intentionally altered on any one or more guns. Thermal process control may be lost during these events, with attendant substrate temperature excursions that may adversely affect the applied coating characteristics (microstructure).

It is a challenge to ensure consistent production while offering protection for the e-beam gun support systems. It is therefore desirable to develop a system and method that protects gun subsystems in the event of an arc within a gun or within the processing environment.

### SUMMARY

Although there are various systems and methods that control filament and beam current for electron beam guns used in vapor deposition, such systems and methods are not completely satisfactory. It would be desirable to have systems and methods that monitor electron beam current and voltage, and react to fault conditions such as arcing experienced during evaporation and deposition processes to shutdown and protect associated power supply equipment.

Although arc down protection and arc recovery systems may be elements of multi-electron beam gun coating systems, and these functions may be provided as a byproduct of the present method and apparatus, the present disclosure can provide enhanced thermal stability that is manifested into the process via electron beam gun filament current control. Thermal stability of the parts in the process is dependent upon input process parameters such as time, temperature, pressure, injected oxygen relationships. These parameters influence the characteristics that determine coating durability. Thus, attempts to control these parameters to improve stability are constrained by the desired coating characteristics.

The disclosure provides online beam current control to provide stable operation of e-beam guns during heating and melting modes of vapor deposition operation. Beam current supplied to each gun used in a process may be monitored. The measured current may be used in a closed-loop feedback control to indirectly adjust beam current by adjusting filament current. Power supply protection may be provided for one or more e-beam guns having a shared, common beam high voltage power supply.

One aspect of the disclosure provides methods for controlling a power supply for an electron beam. Methods according to this aspect may start with defining a high voltage level setpoint for a high voltage beam power supply output, defining a beam current setpoint, defining a filament current setpoint for a filament power supply output, monitoring the high voltage beam power supply output voltage, monitoring current supplied to a cathode of the electron beam, and determining whether a fault condition has occurred based on the high voltage beam power supply output voltage and filament current.

Another aspect involves deriving a beam current value based on the filament current and the high voltage beam power supply voltage.

Yet another aspect of the disclosure is an electron beam power supply system. Systems according to this aspect of the disclosure comprise a high voltage beam power supply having an output coupled to a cathode of the electron gun, a filament power supply having an output coupled to a filament of the electron gun, and a processor monitoring voltage applied to the cathode and current applied to the filament, the processor outputting control signals to the high voltage beam power supply and the filament power supply wherein the control signals are responsive to the cathode voltage and the filament current and indicate fault conditions experienced by the electron beam.

Another aspect of the system involves a high voltage output level setpoint for predetermining a high voltage level, a filament power supply current setpoint for predetermining a filament current level, and a beam current setpoint for predetermining a beam current level wherein the beam current depends on the high voltage level and the filament current level.

Other objects and advantages of the methods and systems will become apparent to those skilled in the art after reading the detailed description.

### BRIEF DESCRIPTION OF THE DRAWINGS

FIG. 1 is an exemplary electron beam gun.
FIG. 2 is an exemplary cross-sectional view of a vapor deposition chamber.
FIG. 3 is an exemplary schematic of a control system.
FIG. 4 is an exemplary plot showing beam current and filament current at various values of high accelerating voltage.
FIG. 5 is a block diagram of an exemplary method according to the invention.
FIG. 6 is an exemplary plot showing system operation during a fault condition.
FIG. 7 is an exemplary schematic of the beam current regulator.
FIG. 8 is an exemplary plot of output signal beam current regulator 317 for filament current control.

### DETAILED DESCRIPTION

Embodiments are described with reference to the accompanying drawing figures wherein like numbers represent like elements throughout. Further, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. The terms "mounted," "connected," and "coupled" are used broadly and encompass both direct and indirect mounting, connecting, and coupling. Further, "connected" and "coupled" are not restricted to physical or mechanical connections or couplings.

The disclosure is not limited to any particular software language described or implied in the figures. A variety of alternative software languages may be used for implementation. Some components and items are illustrated and described as if they were hardware elements, as is common practice within the art. However, various components in the method and system may be implemented in software or hardware.

Embodiments provide systems and methods for controlling filament current for electron beam guns used in vapor deposition.

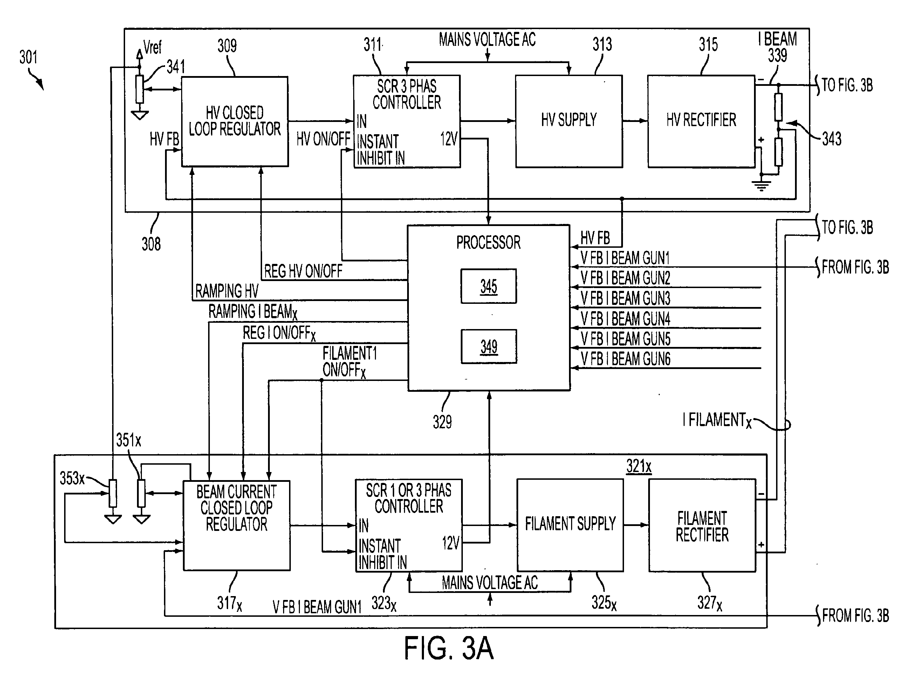

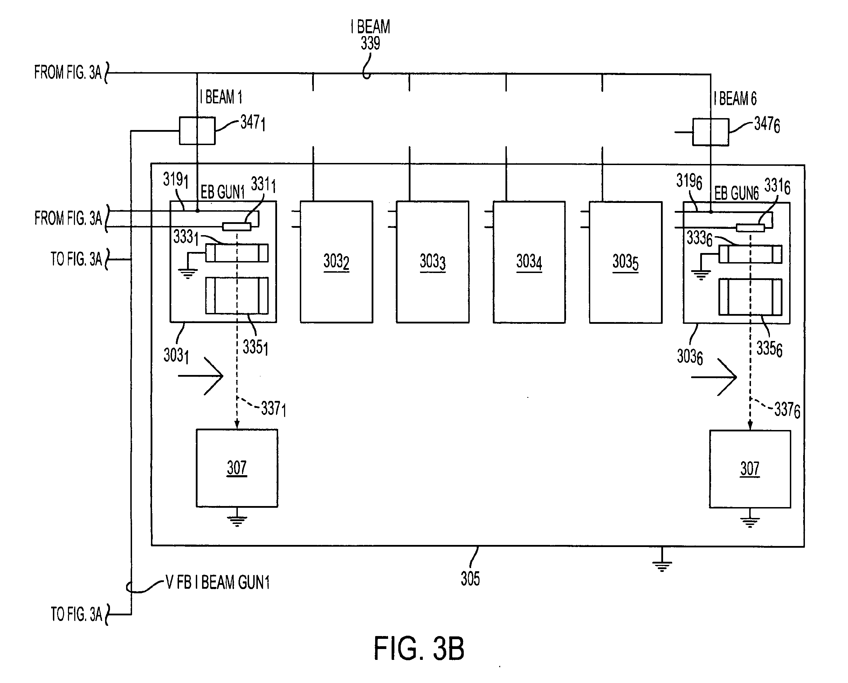

FIG. 3 is a schematic of a deposition control system 301. The exemplary system uses six e-beam guns. However, other numbers of guns may be employed. The subscript ₓ identifies components and signal paths that are associated with one gun (ₓ = 1, 2, 3, ... 6).

The control system 301 controls the beam current (I_BEAM) supplied to all guns 303ₓ (I_BEAMₓ) used in a process chamber 305 for PVD. The amount of beam current (I_BEAMₓ) supplied to each gun 303ₓ depends on the magnitude of the accelerating voltage and filament current (I_FILAMENTₓ).

During vapor deposition, the chamber 305 vacuum, the properties of the material 307 being evaporated, electrical arcing, and other phenomena which occur inside the chamber 305 during processing all may affect gun 303ₓ filament current (I_FILAMENTₓ). The simultaneous operation of several guns 303ₓ sourced from a common high voltage (HV) power supply affect gun 303ₓ stability.

The common HV beam power supply system 308 includes an HV closed loop regulator 309, an SCR controller 311, an HV power supply 313, and an HV rectifier 315. The HV rectifier outputs an HVDC (direct current) to the gun cathodes (I_BEAM).

The system 301 uses a thyristor regulator 317ₓ in the filament current path for each gun 303ₓ in conjunction with closed-loop feedback as part of the overall control. Each gun 303ₓ has a dedicated filament regulator system 321ₓ that includes a beam current regulator 317ₓ, an SCR controller 323ₓ, a filament supply 325ₓ, and a filament rectifier 327ₓ.

The beam current regulator 317ₓ takes into account operational features of ENERPRO Corporation SCR series FCOG 6100 (three phase firing board) or FCRO 2100 (single phase firing/regulator board) controllers. The level of FCRO 2100 firing board input command is from 0 up to +5VDC; at the same time delay angle varies from 180 to 0 degrees. Other devices with the appropriate specifications can be used.

The system controls beam current (I_BEAM) in dependence on individual gun filament current (I_FILAMENTₓ). Individual beam current (I_BEAMₓ) feedback (V_FB_I_BEAM_GUNₓ) provides an independent, on-line control for each gun 303ₓ in use and provides stable operation for different processing modes. Presetting filament current (I_FILAMENTₓ) decreases the value of beam current deviation if the system terminates on a fault or HV arc which may occur in the chamber during processing.

A processor 329 accepts feedback from the common HV output 339 (HV_FB), individual gun 303ₓ beam current (V_FB_I_BEAM_GUNₓ), and based on a control logic, outputs in response to the feedback signals that control the common HV power supply system 308 and each gun filament regulator system 321ₓ. An HV voltage divider 343 provides a low voltage representation of the HV output 339 as feedback (HV_FB).

Each gun 303ₓ comprises a cathode 331ₓ, an accelerating electrode 333ₓ and a deflection coil 335ₓ. DC filament current 319ₓ (I_FILAMENTₓ) heats the cathode 331ₓ liberating electrons from its surface through thermionic emission.

The cathode 331ₓ is coupled to a negative output of the HV rectifier 315. The corresponding positive output of the HV rectifier 315 is coupled to a chamber 305 ground terminal and an accelerating electrode 333ₓ ground terminal for each gun 303ₓ. When high voltage is applied to each cathode 331ₓ, electrons are emitted and accelerate through the accelerating electrode 333ₓ forming an electron beam 337ₓ.

The deflection coil 335ₓ rasters the electron beam 337ₓ over an object 307 for evaporation, or tray (not shown) for heating within in the chamber 305. A discussion of raster control is beyond the scope of this disclosure.

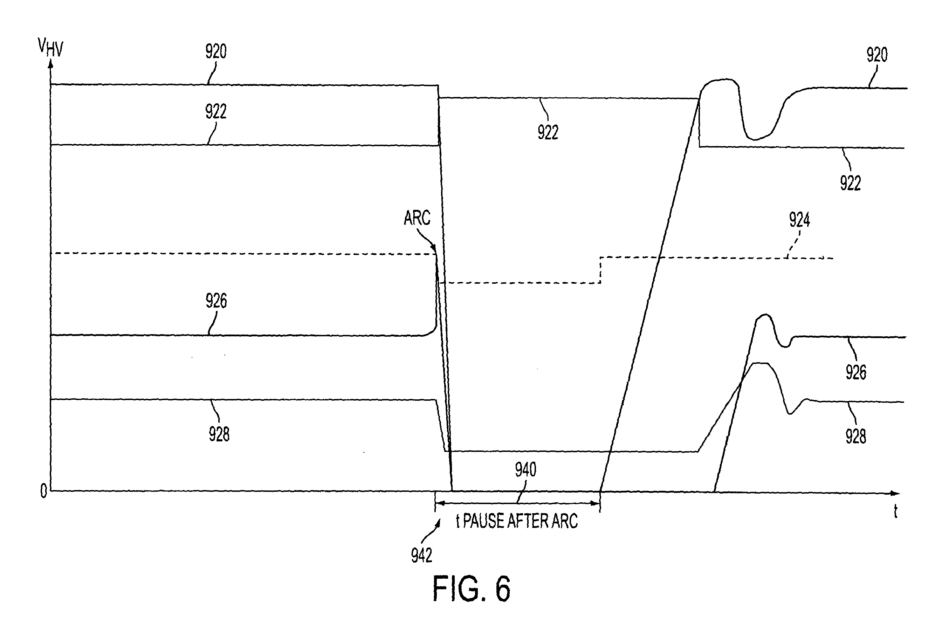

Process parameters such as heating, and evaporant temperature and rate depend upon the cathode and filament currents. Two plots of HV beam current versus filament current corresponding to two different HV setpoints are shown in FIG. 6. The Y axis shows the reading of controllable value in arbitrary units. X axis - time. Unit of measurement is defined by the name of controllable value. Various controllable values are shown on one Y axis for better understanding of their dependency in time: HV level 920; HV threshold comparator detector level 922; arc comparator detector current level 924; beam current 926; filament current 928.

The HV feedback (HV_FB) is coupled to the HV regulator 309 and to an HV level comparator 345 input that is part of the processor 329. Beam current sensors 347ₓ produce beam current values (V_FB_I_BEAM_GUNₓ) corresponding to each gun 303ₓ.

An arc detector 349 which is part of the processor 329 logic monitors the HV level. The system may enable beam current regulators of live guns as soon as HV level reaches desired value (e.g., 90% of operating voltage HV). An arc detector 349 is used to detect over current conditions which indicate shorting or HV arcing. Beam current (V_FB_I_BEAM_GUNₓ) is also used as feedback for the beam current regulator 317ₓ. The system compensates for electron beam 337ₓ perturbations that occur by monitoring the variation of each gun's beam current and voltage.

The power source for the SCR controller 311 and HV supply 313 is three phase alternating current (ac). Single phase ac is supplied to the SCR controller 323ₓ and the filament supply 325ₓ.

The processor 329 analyzes the beam (I_BEAM) (HV_FB) and current (V_FB_I_BEAM_GUNₓ) feedback. Processor 329 logic analyzes whether an over current condition exists. The processor 329 controls the common HV power supply system 308 and each gun filament regulator system 321ₓ.

The processor 329 outputs on/off control commands to the common HV power supply system 308 SCR controller 311 (HV_ON/OFF) and HV regulator 309 (REG_HV_ON/OFF), and each gun filament regulator control system 321ₓ beam current regulator 317ₓ (REG_I_ON/OFFₓ) and SCR controller 323ₓ (FILAMENT_ON/OFFₓ) thereby turning on the common power supply 308 and gun filament regulator systems 321ₓ to energize or de-energize a gun.

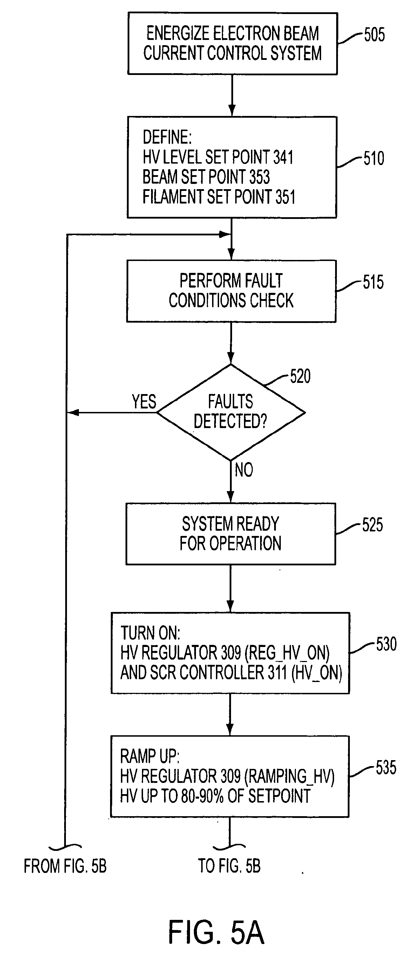

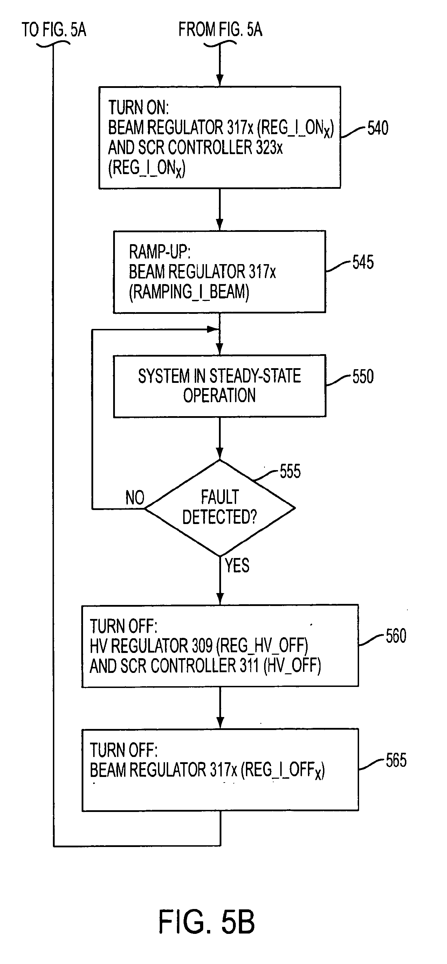

A method of operation is shown in FIG. 5. After applying power to the system (step 505), a user adjusts the HV level setpoint 341, beam setpoint 353, and filament setpoint 351 values (step 510).

The processor 329 reviews a list of permissives regarding possible electrical fault conditions for a determination of system availability (step 515). If no fault conditions are found (step 520), the gun system is ready for operation (step 525). The invention turns on the HV regulator 309 (REG_HV_ON) and SCR controller 311 (HV_ON) (step 530) and gradually ramps-up (RAMPING_HV) the HV power supply output 339 via the regulator 309 to the HV level setpoint 341 (step 535).

The HV level setpoint 341 is used to define a desired HV level. The beam current regulator 317ₓ (REG_I_ONₓ) and SCR controller 323ₓ (FILAMENT_I_ONₓ) are then turned on (step 540).

As soon as the predetermined HV level is reached, the beam current regulator 317ₓ output ramps-up (RAMPING_I_BEAMₓ) to its setpoint 351 (step 545). The system is in operation (step 550).

If a fault condition occurs (step 555), the arc detector 349 turns the processor 329 control outputs for the SCR regulator 311 (HV_OFF), HV regulator 309 (REG_HV_OFF), beam current regulator 317x (REG_I_OFFx) to OFF (steps 560, 565), thereby de-energizing beam 308 power supplies and shutting down the evaporating tools for a finite period of time. If one gun arcs, all guns may be shutdown. The desired finite period of time depends upon the properties of evaporating materials and may vary within the range of 0.2-5 seconds. The duration of such time is adjusted through the adjustment of the duration of disabling pulse (t pause 940 after arc 942 in FIG. 6) that is generated by arc detector 349 as soon as arc is detected.

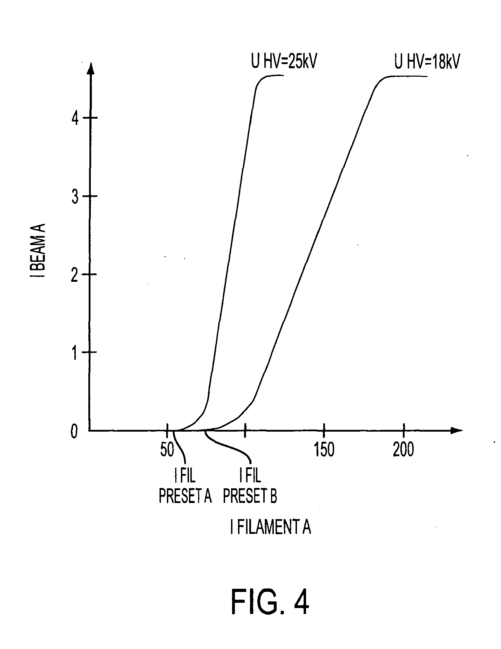

FIG. 6 is a plot of an arc transient and the system response over time. Beam current lags behind filament current because of cathode thermal lag. Lines of filament current and beam current are shown in arbitrary units since beam current value depends upon the gun design, cathode material, working value of accelerating voltage. Filament set point 351 value depends upon these factors as well. Line 924 of ARC Level shows the thresholds of arc current detector 349 response for each gun. Beam current increase up to the preset value of arc level causes arc current detector 349 to generate control pulse (t pause after ARC) that disables high-voltage source and beam current regulators of all guns. Lines beam current 926 and filament current 928 show beam current and gun filament values. As soon as arc current detector 349 detects arcing it disables high-voltage source and beam current regulators of all guns. At the same time beam current rapidly drops down to 0 and filament current decreases to the preset value Fil Preset (see FIG.4). Available filament current keeps hot state of cathode and protects cathode from abrupt variation of its length at beam current enabling\disabling. As soon as HV level reaches 90% of operating voltage HV threshold detector 345 allows enabling of beam current regulators. Such control logic provides beam setting (hit) to the initial position. Filament current increases at the preset ramping and restores the working value of beam current.

When the processor 329 logic determines that the fault has ended and the event is over (step 515) and operation can resume (step 520), the HV regulator 309 and SCR controller 311 are reset and turned on ((REG_HV_ON), (HV ON)) (step 525). At the same time, a power supply ramping signal (RAMPING_HV) is output from the processor 329 that ramps-up the regulator 309 output to the HV setpoint 341 (step 530).

A filament on signal (FILAMENT_ON) is output from the processor 329 to SCR controller 323ₓ and beam regulator 317ₓ in addition to a beam current regulator 317ₓ on signal (REG_I_ONₓ) (step 535).

Processor 329 outputs the beam current regulator ramping signal (RAMPING_I_BEAMₓ) when the beam voltage (HV_FB) reaches 80%-90% of the HV setpoint 341 (step 540). The system returns to operation (step 545).

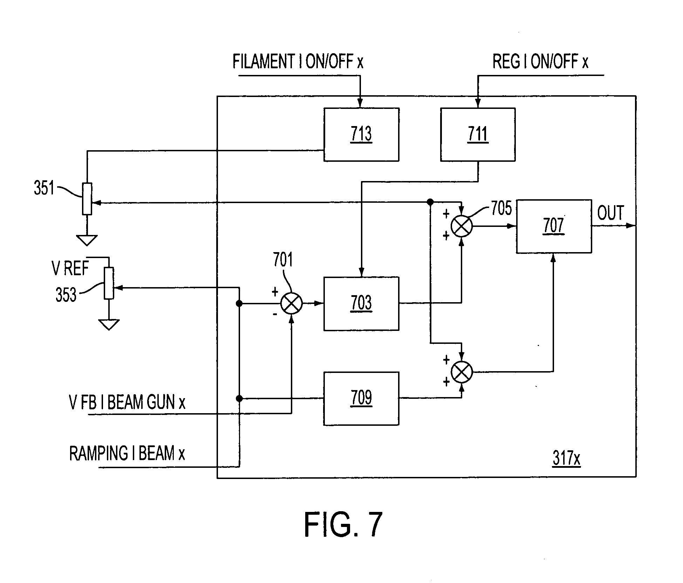

FIG. 7 is the beam current regulator 317ₓ for each filament regulator system 321ₓ. The filament current setpoint 351 allows for the smooth ramp-up of filament current as soon as the SCR controller 323ₓ is turned on (FILAMENT_I_ONₓ).

The beam current setpoint is set via potentiometer 353 or from another analog device. A comparator 701 compares a desired beam current setpoint 353 against actual beam current feedback (V_FB_I_BEAM_GUNx) and outputs a difference, or error signal. The error signal is amplified by a PI (proportional-integral) error amplifier 703. An analog adder 705 adds the filament current setpoint 351 to the amplifier 703 output.

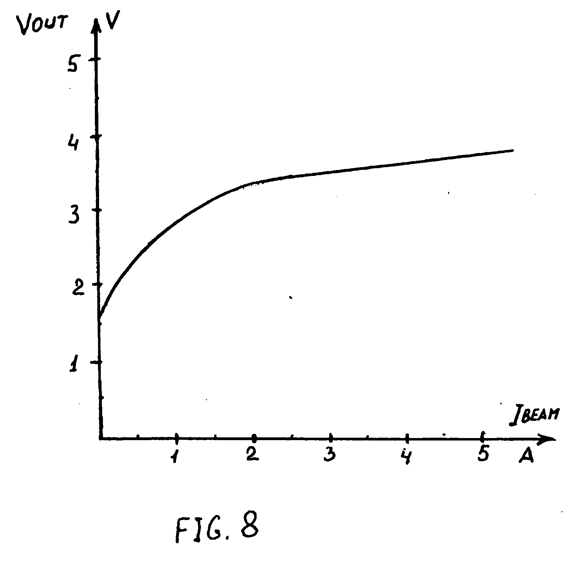

A limiter 707 limits the output of the adder 705 output preventing saturation using the beam current setpoint 353 which is non-linear amplified 709 and added with the filament setpoint 351 which modifies the limit 707. FIG. 8 shows the output signal current regulator 317 for filament current control.

A control device 711 (e.g., an electronic switch) outputs a signal in response to the beam regulator signal (REG_I_ON/OFFₓ) that modifies the characteristics of the error amplifier 703 during arcing. As soon as arc occurs control device 711 disables the error amplifier 703. In this case output signal of regulator 317 corresponds to I Fil preset (see FIG. 4)

Filament current presetting 713 sets I filament level via the regulator 317x when guns filament is ON. Such filament level is adjusted for each gun individually from filament set point 351. An adjustment procedure for finding set point 351 is: 1) preset HV Set point 341 at operating level HV; 2) preset set point I beam 353 to approximately 0 mA; 3) increase slowly the filament set point 351 until beam current is about 5 mA. Fix the resultant value as filament set point 351.

The disclosure facilitates operating mode of regulator 317x and cathode 331x of a gun at beam current stabilization. The use of closed loop beam current feedback in regulator 317x which control of prefabricated SCR controller 323 of filament current of each EB gun provides stable operation of the system under various modes of evaporation and deposition. Points I_FIL_PRESET A and B in Fig.4 can be considered as initial value of cathode filament at operating accelerating voltage 25 kV (point A) or 18 kV(point B).

Points A, B show approximate values of filament current at 25 kV and 18 kV accelerating voltage when beam current starts showing up.

The control is carried out in the following manner. See FIG.3B, FIG.4. Filament set point 351 sets initial current value of cathode filament (I Fil preset), that depends upon the preset operating voltage of HV supply (see points A, B FIG.4). Beam set point 353 sets signal level for Beam current close loop regulator 317 that transmits the command to the input of SCR CONTROLLER 323 that provides control over silicon-controlled rectifiers of Filament Supply 325. From the output of Filament Supply 325 filament, gate voltage is supplied to filament current rectifier 327 that provides control over DC filament current 319 of cathode 331 of gun 303. Signal of beam current-sensing device 3A7 of the gun 303 is used as the signal of negative feedback in beam current close loop regulator 317. Beam current value deviation from the preset value causes regulator 317 to generate filament control signal that compensates beam current variation.

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the scope of the present invention as defined by the appended claims.

## Claims

1. An electron beam power supply comprising:
a beam power supply (308) having an output coupled to a cathode (331x) of an electron beam;
a filament power supply (321x) having an output coupled to a filament of the electron beam; and
a processor (329) monitoring voltage applied to said cathode (331x) and current applied to said filament, said processor (329) outputting control signals to said high voltage beam power supply (308) and said filament power supply (321x) wherein said control signals are responsive to said cathode voltage and said filament current and indicate fault conditions experienced by the electron beam.

2. The power supply according to claim 1 further comprising:
a high voltage output level setpoint (341) for predetermining a high voltage level;
a filament power supply current setpoint (351) for predetermining a filament current level; and
a beam current setpoint (353) for predetermining a beam current level wherein said beam current depends on said high voltage level and said filament current level.

3. A method for controlling a power supply for an electron beam comprising:
defining a high voltage level setpoint (341) for a high voltage beam power supply output;
defining a beam current setpoint (353);
defining a filament current setpoint (351) for a filament power supply output;
monitoring said high voltage beam power supply output voltage;
monitoring current supplied to a cathode (331x) of the electron beam; and
determining whether a fault condition has occurred based on said high voltage beam power supply output voltage and said filament current.

4. The method according to claim 3 further comprising terminating said high voltage beam power supply output and said filament power supply output upon a fault condition.

5. The method according to claim 4 further comprising deriving a beam current value based on said filament current and said high voltage beam power supply voltage.

6. A deposition apparatus comprising:
a chamber (305) having an interior;
at least one electron gun (303x) positioned and oriented to direct an associated electron beam within the deposition chamber (305);
a control system coupled to the at least one electron gun (303x) having a beam power supply (308) having an output coupled to a cathode (331x) of an electron beam;
a filament power supply (321x) having an output coupled to a filament of the electron beam; and
a processor (329) monitoring voltage applied to said cathode (331x) and current applied to said filament, said processor (329) outputting control signals to said high voltage beam power supply (308) and said filament power supply (321x) wherein said control signals are responsive to said cathode voltage and said filament current and indicate fault conditions experienced by the electron beam.

7. The apparatus of claim 6 wherein:
the at least one electron gun comprises a plurality of electron guns (303x).

8. A deposition apparatus comprising:
a chamber (305) having an interior;
a plurality of electron guns (303x) positioned and oriented to direct an associated electron beam within the deposition chamber (305); and
a control system coupled to the pluralities of electron guns (303x) and having at least a first thyristor regulator (317x) providing closed loop feedback of at least a first gun of said at least one electron gun (303x).

9. The apparatus of claim 8 wherein:
the at least one thyristor regulator (317x) comprises a plurality of comprises a plurality of thyristor regulators providing closed loop feedback of a respective plurality of electron guns of said at least one electron gun.

10. The apparatus of claim 8 wherein:
the at least one thyristor regulator (317x) comprises 4-8 thyristor regulators; and
the at least one electron gun consists of 4-8 electron guns (303x), each controlled by at least an associated one of the thyristor regulators (317x).
